Europäisches Patentamt

European Patent Office

Office européen des brevets

(19)

(11) **EP 0 704 709 A2**

(12) **EUROPÄISCHE PATENTANMELDUNG**

(43) Veröffentlichungstag:
03.04.1996 Patentblatt 1996/14

(51) Int Cl.⁶: **G01R 31/34**

(21) Anmeldenummer: **95113063.2**

(22) Anmeldetag: **19.08.1995**

(84) Benannte Vertragsstaaten:
**DE FR GB**

(30) Priorität: **29.09.1994 DE 4434749**

(71) Anmelder: **LUST ANTRIEBSTECHNIK GmbH**
**D-35633 Lahnau-Waldgirmes (DE)**

(72) Erfinder: **Ruff, Michael**
**D-35644 Hohenahr (DE)**

(74) Vertreter: **Missling, Arne, Dipl.-Ing.**
**Patentanwalt**
**Bismarckstrasse 43**
**D-35390 Giessen (DE)**

(54) **Verfahren zur Bestimmung der elektrischen Parameter von Asynchronmotoren**

(57) Das Verfahren zur Bestimmung der elektrischen Parameter eines von einem Pulswechselrichter (Umrichter) gespeisten Asynchronmotores im Stillstand ist dadurch gekennzeichnet, daß zunächst der Widerstand von Umrichter und Asynchronmotor in Abhängigkeit des gemessenen Strangstromes $i_{Sa}$ bei vorgegebenen Sollspannungen $U_S$ für den Umrichter bestimmt wird, wobei der Strangstrom $i_{Sa}$ vorteilhaft nicht unter 10 % des Nennstromes eines Leistungshalbleiters des Umrichters liegen sollte, daß anschließend
die an den Strängen des Asynchronmotors anliegende Ist-Spannung $\hat{u}_{Sa}$ und der Ständerwiderstand $^{\wedge}R_S$ mittels eines linearen Regressionsverfahren unter Verwendung der gemessenen Strangströme $i_{Sa}$ und der zugehörigen Soll-Spannungen $U_S$ gemäß Gleichung 2.8 errechnet wird, daß
anschließend zur Bestimmung der Streuinduktivität $^{\wedge}L_{RS\sigma}$ und des Rotorwiderstandes $^{\wedge}R_R$ im linearen oberen Bereich der gemäß Gleichung 2.8 ermittelten Stromspannungskennlinie im Anschluß an den Einschwingvorgang bei vorgegebenem Spannungs-Sollwert $U_{S1}$ ein zweiter höherer Spannungs-Sollwert $U_{S2}$ vorgegeben wird und der zeitliche Verlauf des Strangstromes $i_{Sa}$
gemessen wird, daß aus den gemessenen Stromwerten $i_{Sa}$ und den hierzu zuvor errechneten Spannungs-Istwerten $\hat{u}_S$ gemäß Gleichung 2.11, die Hilfsparameter $a_1$ und $a_2$, $b_1$ und $b_2$ mit den rekursiven Parameterschätzverfahren ($R_{LS}$ - Algorithmus) geschätzt werden, aus denen durch Umrechnung gemäß den Gleichungen 2.12 bis 2.26 die Streuinduktivitäten $^{\wedge}L_{RS\sigma}$ und Rotorwiderstand $^{\wedge}R_R$ berechnet werden, daß
anschließend zur Bestimmung der stromabhängigen Hauptinduktivität $^{\wedge}L_h$ die unerregte Asynchronmaschine mit einem Spannungs-Sollwert beaufschlagt und der zeitliche Verlauf des Strangstromes $i_{Sa}$ gemessen und gemäß Gleichung 2.27 der zeitliche Verlauf des Statorflusses $^{\wedge}{}_{Sa}$ und dann anschließend gemäß Gleichung 2.29 die Hauptinduktivität $^{\wedge}L_h$ errechnet wird, wobei dieser Meß- und Rechenvorgang für unterschiedliche Spannungs-Sollwerte $U_S$ wiederholt wird und daß
aus den zuvor errechneten stromabhängigen Hauptinduktivitäten $^{\wedge}L_h$ die Kennlinie $L_h = f(i_\mu)$ gemäß Gleichung 2.30 als Funktion des Magnetisierungsstromes $i_\mu$ approximiert wird.

$U^*_{S\alpha}$

$U^*_{S\alpha}(1,5I_N)$

$U^*_{S\alpha}(I_N)$

Phase

① ② ③ ④ ⑤ ⑥

$i_{S\alpha}(t)$

$I_{S\alpha}$

$\Delta i_{S\alpha}(t)$

$i_{S\alpha}(t)$

$U^*_{S\alpha}(I_N)$

$\Delta u_{S\alpha}(I_{s\alpha}), \hat{R}_S$

$\hat{L}_\sigma, \hat{R}_R$

$\hat{\Psi}_{S\alpha}, \hat{L}_S, \hat{L}_h(I_\mu)$

Bild 7: Testsignalfolgen zur Bestimmung der elektrischen Parameter im Stillstand

**Beschreibung**

Die Erfindung betrifft ein Verfahren zur Bestimmung der elektrischen Parameter eines von einem Pulswechselrichter (Umrichter) gespeisten Asynchronmotores im Stillstand.

Die Regelung von Asynchronmaschinen setzt die Kenntnis der elektrischen Parameter und zwar die des Statorwiderstandes $R_S$, des Rotorwiderstandes $R_R$, der stator- und rotorseitigen Streuinduktivität $L_{S\sigma}$, $L_{R\sigma}$ sowie der stromabhängigen Hauptinduktivität $L_h$ voraus.

Bekannt ist es, den Statorwiderstand durch Gleichspannungsmessungen, die Streuinduktivität und den Rotorwiderstand durch Auswertung von Kurzschlußversuchsreihen sowie die stromabhängige Hauptinduktivität durch Auswertung von Leerlaufversuchen zu ermitteln. Diese drei unterschiedlichen Versuchsdurchführungen erfordern drei unterschiedliche Meßaufbauten. Bei den Gleichspannungsmessungen benötigt man ein entsprechendes leistungsfähiges Netzteil. Die Durchführung der Kurzschlußversuche kann nur bei mechanischer Blockade des Läufers und Speisung an einem symmetrischen Drehstromnetz erfolgen. Der Leerlaufversuch erfordert einen Synchronlauf des Rotors, was nur durch ein zusätzliches Antreiben des Asynchronmotores mit einer zusätzlichen Maschine, in den meisten Fällen einer geregelten Gleichstrommaschine, erreicht werden kann.

Da darüber hinaus die Inbetriebnahme der Regelung vorteilhaft erst vor Ort erfolgen sollte, ist dieses Verfahren zur Parameterbestimmung deshalb nicht durchführbar, weil der Motor und die Last bereits mechanisch fest verkoppelt sind und die Regelung des Asynchronmotores nur durch einen mit dem Asynchronmotor vorgeschalteten Pulswechselrichter (auf einem weiteren Umrichter) durchgeführt werden kann. Dies bedeutet, daß die Parameterbestimmung im Stillstand erfolgen muß, wobei der Rotor jedoch nicht mechanisch blockiert ist.

Aus der DE-A-41 03 270 ist es bekannt, die Ständerflußverkettung einer Drehstrommaschine und daraus die differenziellen Wicklungsinduktivitäten aus den gemessenen Leiterspannungen und gemessenen Ständerströmungen zu ermitteln. Auch gemäß der DE-A-42 35 607 wird der Ständerfluß eines Asynchronmotores auch aus den gemessenen Ständerspannungen und Ständerströmen ermittelt, um dann bei bekannter Ständerinduktivität und Streuinduktivität ein Schätzwert des Statorwiderstandes zu errechnen.

Des weiteren ist es aus dem Aufsatz von Schierling, H. "Selbsteinstellendes und selbstanpassendes Antriebsregelsystem für die Asynchronmaschine mit Pulswechselrichter" (Diss. TH Darmstadt 1987) bekannt, anhand gemessener Spannungseingangs- und Stromausgangssignale unterschiedlicher transienter Vorgänge die elektrischen Parameter zu bestimmen.

Alle die vorstehend genannten Arbeiten setzen jedoch ein Messen der umrichterseitigen Ausgangsspannung voraus.

Des weiteren ist es bekannt, die Strom- und Spannungskennlinie eines Umrichters durch Ausmessen vor dem Anschluß an den Motor zu bestimmen. Dieses Verfahren hat jedoch den Nachteil, daß die motorseitigen Werte entweder bekannt oder mit einem anderen Verfahren ermittelt werden müssen.

Auch ist ein Verfahren zur Bestimmung der elektrischen Parameter von Asynchronmaschinen bekannt, bei dem vier Testsignale aufgeschaltet werden, die derart bestimmt sind, daß der jeweils darauf resultierende Ausgleichsvorgang des Stromes nur von einem elektrischen Parameter abhängt.

Allen diesen bekannten Verfahren haftet der Nachteil an, daß diese äußerst aufwendig sind und insbesondere die Spannungserfassung einen großen apparativen Aufwand erfordern. Die Spannungserfassung muß auf die Zwischenkreisspannung (ca. 400 x $\sqrt{3}$ Volt) ausgelegt sein und darüber hinaus muß eine Mittelwertbildung des gemessenen Signals unter Verwendung zusätzlichen apparativen Aufwandes gebildet werden.

Bei einer Bestimmung der Parameter im Stillstand sind auch Spannungspegel möglich, die um den Faktor 100 kleiner sind als die Zwischenkreisspannung. Aufgrund der Auslegung der Meßwerterfassung auf die maximale Spannung (Zwischenkreisspannung), bedeutet dies wiederum eine hohe Anforderung an die einzusetzenden Bauteile, insbesondere an die benötigten Analog-Digital-Umsetzer. Weitere zusätzliche Kosten werden durch die Bauteile verursacht, die zur erforderlichen Mittelwertbildung notwendig sind.

Durch die Aufnahme der Stromspannungskennlinie des Umrichters vor dem Anschließen an den Motor kann zwar der Nachteil der Spannungserfassung umgangen werden, jedoch besteht dann das Problem, daß der entstehende Spannungsabfall immer eine Rückwirkung der angeschlossenen Last auf den Motor zur Folge hat. Aufgrund der Reihenschaltung von Umrichter und Motor ist dieser Effekt bei Inbetriebnahme zu berücksichtigen. Dies kann jedoch immer nur in Verbindung mit dem jeweilig dazugehörigen Motor durchgeführt werden. Eine Nichtberücksichtigung führt zu fehlerhaften Parameter.

Die Bestimmung der elektrischen Parameter durch die unterschiedlichen Testsignale wird zwar in der Praxis eingesetzt, jedoch ist durch dieses Verfahren eine Bestimmung der stromabhängigen Hauptinduktivität nicht möglich.

Der Erfindung liegt die Aufgabe zugrunde, ein kostengünstiges Verfahren zur Bestimmung der elektrischen Parameter von Asynchronmotoren vorzuschlagen, das vor Ort vorgenommen werden kann, d. h. bei dem der Asynchronmotor einschließlich Umrichter und Last fest installiert sind.

Diese Aufgabe wird mit den Merkmalen des Anspruches 1 gelöst. Ein vorteilhaftes Verfahren geht aus dem Anspruch 2 hervor. Dieses erfordert zwar einen geringeren Meßaufwand, dafür jedoch einen größeren Rechenaufwand.

Nachstehend wird das erfindungsgemäße Verfahren beschrieben. Hier werden alle konstanten elektrischen Modellparameter sowie die stromabhängige Hauptinduktivität von Asynchronmotoren im Stillstand allein durch die Strangstromerfassung ermittelt. Als Testsignalgenerator wird hierzu ein aus einem Gleichspannungszwischenkreis gespeister Umrichter verwendet.

Im Stillstand kann die Asynchronmaschine durch folgendes lineare Differentialgleichungssystem beschrieben werden, wenn man zunächst einmal annimmt, daß die Drehfeldhauptinduktivität nicht vom Magnetisierungsstrom abhängt

$$\begin{bmatrix} \overset{*}{u}_{S\alpha} \\ 0 \end{bmatrix} = \begin{bmatrix} L_S - \dfrac{L_h^2}{L_R} & \dfrac{L_h}{L_R} \\ 0 & 1 \end{bmatrix} \dfrac{d}{dt} \begin{bmatrix} i_{S\alpha} \\ \psi_{R\alpha} \end{bmatrix} + \begin{bmatrix} R_S & 0 \\ -\dfrac{L_h}{T_R} & \dfrac{1}{T_R} \end{bmatrix} \begin{bmatrix} i_{S\alpha} \\ \psi_{R\alpha} \end{bmatrix} \quad . \qquad (2.1)$$

Die darin enthaltenen physikalischen Parameter sind wie folgt definiert:

● $R_S$... Ohm'scher Widerstand der Statorwicklungen
● $L_h$... Drehfeldhauptinduktivität
● $L_S$, $L_R$... Stator- bzw. Rotorinduktivität mit

$$L_S = L_R = L_{R,S} = L_h + L_{R,S_\sigma} \qquad (2.2)$$

●der Rotorzeitkonstante

$$T_R = \frac{L_R}{R_R} \qquad (2.3)$$

● mit dem ohm'schen Widerstand des Rotors $R_R$.

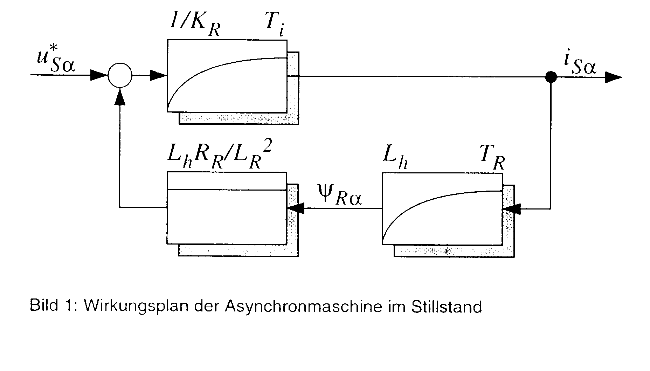

Mit Hilfe des in Gleichung (2.1) definierten Modells ergibt sich der in Bild 1 dargestellte Wirkungsplan.
Die dann enthaltenen Parameter sind wie folgt definiert

$$K_R = R_S + R_R \cdot \frac{L_h^2}{L_R^2} \qquad (2.4)$$

$$T_i = \frac{L_S \cdot L_R - L_h^2}{L_R^2 \cdot R_S + L_h^2 \cdot R_R} \cdot L_R. \qquad (2.5)$$

Beim Einsatz eines Pulswechselrichters, der aus drei 2-Quadraten Gleichstromstellern aufgebaut ist, müssen die Einschaltbefehle der einzelnen Transistoren um die sogenannte Einschaltverzögerungszeit $T_{dON}$ verzögert werden, so daß ein Kurzschluß der Zwischenkreisspannung vermieden wird. Diese Einschaltverzögerungszeit muß größer als die maximal geschätzte Ausschaltzeit $T_{dOFF}$ der Transistoren sein. Die Ausschaltzeiten von Transistoren sind jedoch nicht konstant, sondern hängen von dem jeweiligen Strangstrom ab.

Die Differenz der Einschaltverzögerung und der Ausschaltzeit

$$\Delta T(i_S) = T_{dON} - T_{dOFF}(i_S), \qquad (2.6)$$

wird als Sicherheitszeit bezeichnet und ist aufgrund der Strangstromabhängigkeit der Ausschaltzeit ebenfalls stromabhängig. Folglich ist die Ausgangsspannung des Wechselrichters um den Wert

$$\Delta u_{S\alpha}(i_S) = \overset{*}{u}_{s\alpha} - u_{S\alpha} \qquad (2.7)$$

verfälscht.

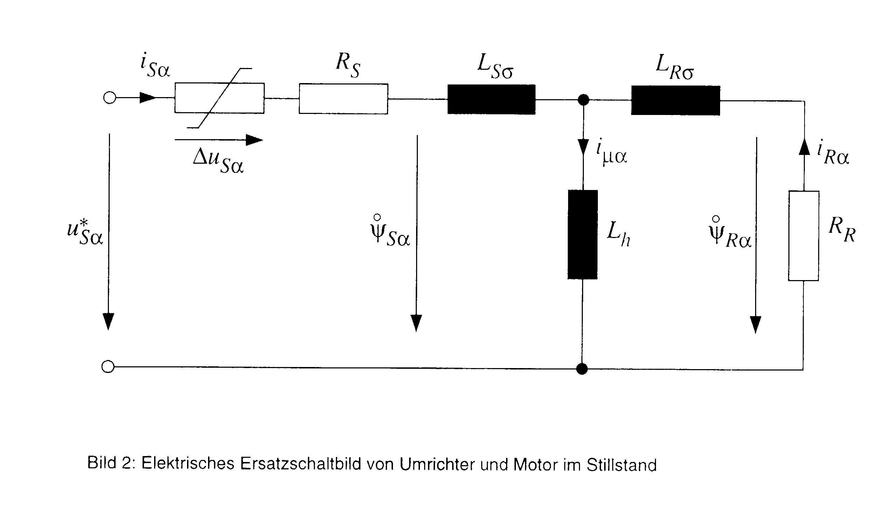

Aufgrund der Reihenschaltung von Umrichter und Motor ist dieser Spannungsabfall bei Nichtverwenden einer Spannungserfassung am Ausgang des Umrichters, nicht von dem Spannungsabfall über der Statorwicklung zu trennen (Bild 2 zeigt die entsprechende Ersatzschaltung im Stillstand).

Den stromabhängigen Spannungsabfall kann man nun durch eine Strom-Spannungs-Kennlinie im ersten Schritt aufnehmen, in dem man unterschiedliche Spannungssollwerte vorgibt und nach Abklingen aller Einschwingvorgänge den Gleichstrom mißt. Die gemessenen Werte können dann unter Verwendung eines linearen Regressionsverfahrens [4] durch folgenden Ansatz

$$\hat{U}_{S\alpha}(I_{S\alpha}) = \underbrace{\hat{U}_{ea} \cdot e^{\hat{k} \cdot I_{S\alpha}} + \hat{U}_{eb}}_{\Delta \hat{u}_{S\alpha}(i_{S\alpha})} + \hat{R}_S \cdot I_{S\alpha} \qquad (2.8)$$

approximiert werden.

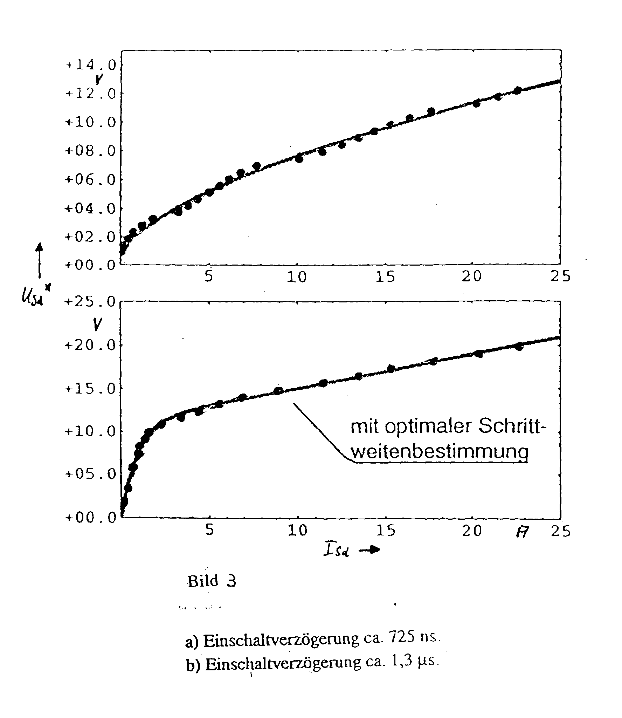

Bild 3 zeigt den gemessenen Strangstrom in Abhängigkeit der angelegten Sollspannung.

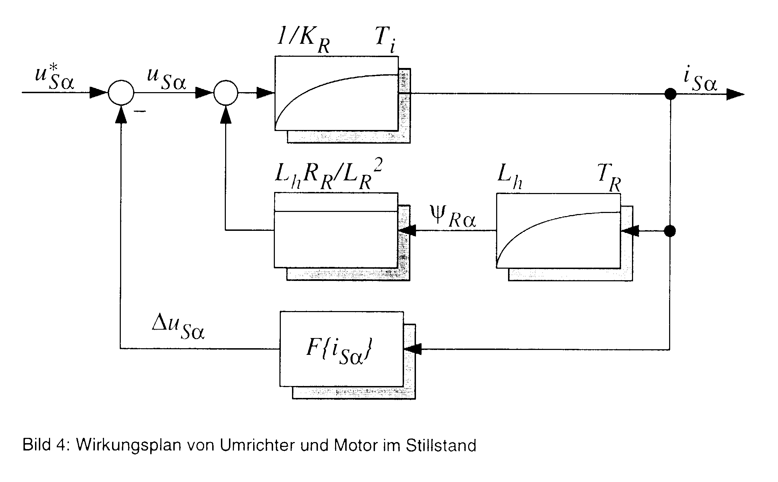

Durch diese Approximation wird nun das Modell im Stillstand (Bild 1) entsprechend erweitert und man erhält den in Bild 4 dargestellten Wirkungsplan.

Um nun den konstanten Spannungsfehler $\hat{U}_{eb}$ in Gleichung (2.8) zu eliminieren muß in einem nächsten Schritt eine Differenzmessung durchgeführt werden, das heißt es wird zunächst ein Spannungssollwert $U_{S\alpha 1}^{*}$ vorgegeben und der statische Endwert $I_{S\alpha 1}$ wird gemessen. Ausgehend von diesem Spannungssollwert wird ein neuer Spannungssollwert $U_{S\alpha 2}^{*}$ vorgegeben und der transiente Vorgang des Stromes gemessen und gespeichert. Unter Verwendung der beiden Endwerte $I_{S\alpha 1}$ und $I_{S\alpha 2}$ können nun zwei Schätzwerte mit Hilfe von Gleichung (2.8) bestimmt werden

$$\hat{U}_{S\alpha 2} - \hat{U}_{S\alpha 1} = \hat{U}_{ea} \cdot (e^{\hat{k} \cdot I_{S\alpha 2}} - e^{\hat{k} \cdot I_{S\alpha 1}}) + \hat{R}_S \cdot (I_{S\alpha 2} - I_{S\alpha 1}) . \qquad (2.9)$$

Der dynamische Vorgang

$$\Delta i_{S\alpha}(t) = i_{S\alpha 2}(t) - I_{S\alpha 1} \qquad (2.10)$$

und die Differenz der geschätzten Spannungswerte aus Gleichung (2.9) werden nun in einem rekursiven Parameterschätzverfahren (RLS-Algorithmus) entsprechend [4] weiterverarbeitet, um daraus die Modellparameter der diskreten Übertragungsfunktion

$$\frac{\hat{i}_{S\alpha}(z)}{u_{S\alpha}^{*}(z)} = \frac{\hat{b}_1 \cdot z^{-1} + \hat{b}_2 \cdot z^{-2}}{1 + \hat{a}_1 \cdot z^{-1} + \hat{a}_2 \cdot z^{-2}} . \qquad (2.11)$$

zu schätzen.

Die in Gleichung (2.11) enthaltenen diskreten Parameter $\hat{a}_1$, $\hat{a}_2$, $\hat{b}_1$, $\hat{b}_2$ stehen über die folgenden Gleichungen

$$\hat{a}_1 = -e^{s_1 \cdot T_{id}} - e^{s_2 \cdot T_{id}} \qquad (2.12)$$

$$\hat{a}_2 = e^{s_1 \cdot T_{id}} \cdot e^{s_2 \cdot T_{id}} \qquad (2.13)$$

$$\hat{b}_1 = r_1 \cdot (e^{s_1 \cdot T_{id}} - 1) + r_2 \cdot (e^{s_2 \cdot T_{id}} - 1) \qquad (2.14)$$

$$\hat{b}_2 = r_1 \cdot e^{s_2 \cdot T_{id}} \cdot (1 - e^{s_1 \cdot T_{id}}) + r_2 \cdot e^{s_1 \cdot T_{id}} \cdot (1 - e^{s_2 \cdot T_{id}}) \qquad (2.15)$$

mit den physikalischen Parametern in Beziehung.

Die in den Gleichungen (2.12) - (2.15) enthaltenen Polstellen und Residuen lassen sich wie folgt definieren

$$s_{1,2} = -\frac{1}{2} \cdot \left( \frac{L_R \cdot (R_s + R_R)}{L_R^2 - L_h^2} \pm \sqrt{\frac{(L_R \cdot (R_s + R_R))^2}{(L_R^2 - L_h^2)^2} - 4 \cdot \frac{R_R \cdot R_s}{L_R^2 - L_h^2}} \right) \qquad (2.16)$$

$$r_1 = \frac{1}{R_s} \cdot \frac{1 + s_1 \cdot T_R}{s_1 - s_2} \qquad (2.17)$$

$$r_2 = \frac{1}{R_s} \cdot \frac{1 + s_2 \cdot T_R}{s_2 - s_1} \qquad (2.18)$$

$T_{id}$ ist die gewählte Abtastzeit, mit der die Daten verarbeitet werden.

Anschließend kann man durch Lösen der folgenden Gleichungen

$$\hat{\beta}_{1,2} = -\frac{\hat{a}_1}{2} \pm \sqrt{\frac{\hat{a}_1^2}{4} - \hat{a}_2} \qquad (2.19)$$

$$\hat{s}_{1,2} = \frac{1}{T_{id}} \cdot ln(\hat{\beta}_{1,2}) \qquad (2.20)$$

$$\begin{bmatrix} \hat{r}_1 \\ \hat{r}_2 \end{bmatrix} = \begin{bmatrix} \hat{\beta}_1 - 1 & \hat{\beta}_2 - 1 \\ \hat{\beta}_2 \cdot (1 - \hat{\beta}_1) & \hat{\beta}_1 \cdot (1 - \hat{\beta}_2) \end{bmatrix}^{-1} \cdot \begin{bmatrix} \hat{b}_1 \\ \hat{b}_2 \end{bmatrix} \qquad (2.21)$$

$$\hat{T}_R = \frac{1}{\hat{s}_1} \cdot \left( \frac{\hat{R}_S \cdot \hat{r}_1}{\hat{s}_2} \cdot (\hat{s}_1 - \hat{s}_2) - 1 \right) \qquad (2.22)$$

$$\hat{L}_{RS} = -\hat{R}_S \cdot \left( \frac{\hat{s}_1 + \hat{s}_2}{\hat{s}_1 \cdot \hat{s}_2} + \hat{T}_R \right) \qquad (2.23)$$

$$\hat{R}_R = \frac{\hat{L}_{RS}}{\hat{T}_R} \qquad (2.24)$$

$$\hat{L}_h = \sqrt{\hat{L}_{RS}^2 - \frac{\hat{R}_R \cdot \hat{R}_S}{\hat{S}_1 \cdot \hat{S}_2}} \qquad (2.25)$$

$$\hat{L}_{RS\sigma} = \hat{L}_{RS} - \hat{L}_h \qquad (2.26)$$

die Schätzwerte für sämtliche physikalischen Parameter bestimmen.

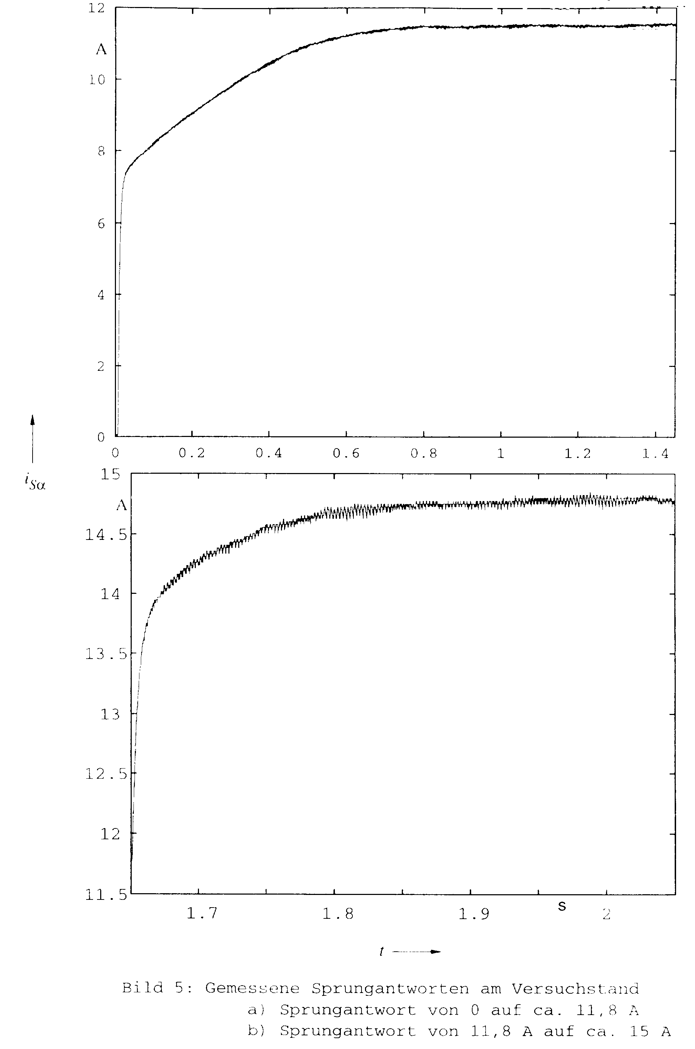

In Bild 5 sind Beispiele der gemessenen Sprungantworten dargestellt.

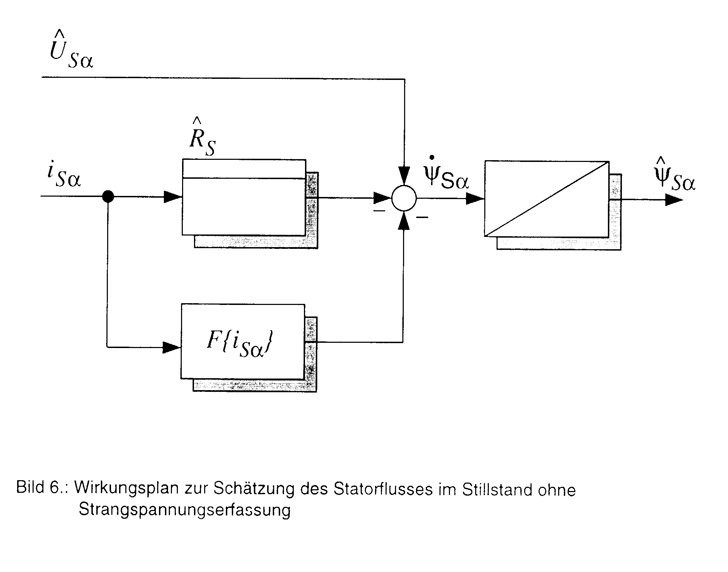

Im nächsten Schritt wird eine Kennlinie $L_h = f(i_\mu)$ ermittelt. Anhand von Bild 2 kann zur Schätzung des Statorflusses der Wirkungsplan gemäß Bild 6 angegeben werden.

Durch Vorgabe eines Spannungssollwertes wird der transiente Übergang (Sprungantwort) des Statorstromes gemessen und gespeichert. Unter Verwendung von Gleichung (2.8) wird ein geschätzter Spannungssollwert $\hat{U}_{S\alpha}$ aus dem gemessenen Stromendwert $i_{S\alpha}(t \to \infty)$ bestimmt. Im darauffolgenden Schritt wird unter Zuhilfenahme der geschätzten Parameter aus Gleichung (2.8) und der gemessenen Sprungantwort die Ableitung des Statorflusses sowie ein Schätzwert des Statorflusses durch die Integration nach der Trapezregel bestimmt.

Aufgrund der Tatsache, daß nach Abklingen aller Einschwingvorgänge $i_{S\alpha}(t \to \infty) = I_\mu$ gilt und die Streuinduktivität bereits im vorangegangenen Schritt bestimmt wurde folgt für die Hauptinduktivität

$$\hat{L}_h(I_\mu) = \frac{\hat{\psi}_{S\alpha}(t \to \infty)}{i_{S\alpha}(t \to \infty)} - \hat{L}_{R\sigma} \ . \qquad (2.29)$$

Dieses Verfahren wird bei unterschiedlichen Stromamplituden, jedes Mal ausgehend von 0 Ampere, durchgeführt und die so erhaltenden Wertepaare werden anschließend durch den folgenden Ansatz approximiert

$$L_h(|i_\mu|) = L_a \cdot e^{|i_\mu| \cdot \alpha_l} + L_b \cdot e^{|i_\mu| \cdot \beta_l} + L_\infty \ . \qquad (2.30)$$

Hierzu wird ebenfalls ein statisches Regressionsverfahren verwendet.

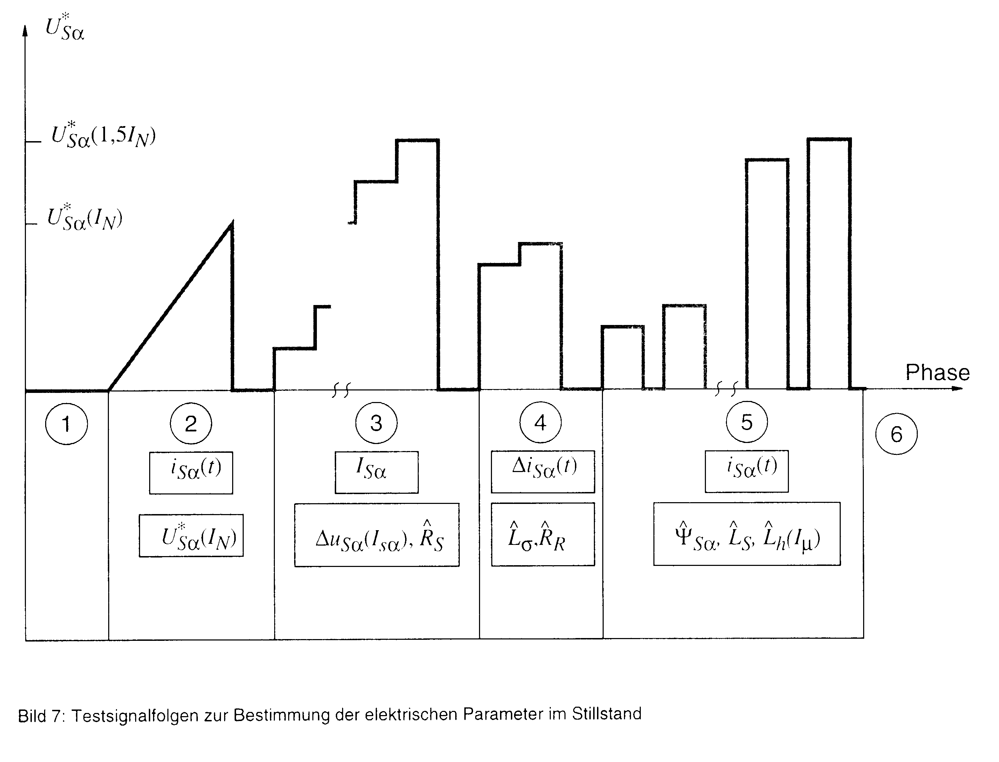

In Bild 7 ist der gesamte Ablauf der Parameterbestimmung nochmals zusammenfassend dargestellt. Es wird nur mit Spannungssollwerten bzw. geschätzten Spannungswerten und gemessenen Stromwerten gearbeitet.

●Phase 1: Eingabe der Leistungsschilddaten

● Phase 2: Ermittlung eines zum eingegebenen Nennstrom gehörenden Spannungssollwertes durch Aufschalten eines rampenförmigen Spannungssollwertes und Messung des Statorstromes
● Phase 3: Durchführung einer Gleichstrommessung bei unterschiedlichen Spannungssollwerten zur Erfassung der U-I-Charakteristik von Umrichter und Motor mit anschließender Bestimmung des Statorwiderstandes
● Phase 4: Bestimmung von Rotorwiderstand und Streuinduktivität entsprechend den Ausführungen in 2.3.
● Phase 5: Bestimmung der stromabhängigen Hauptinduktivität entsprechend 2.4
● Phase 6: Einstellung der Stromregler und des Feldmodells bei der Verwendung einer feldorientierten Regelung.

Die Bestimmung der Strom-Spannungs-Kennlinie kann auch durch eine einzige Messung aus dem dynamischen Vorgang der Sprungantwort bestimmt werden, wobei allerdings ein erhöhter Rechenaufwand betrieben werden muß. Hierzu ist das lineare Schätzmodell (Gleichung 2.11) zu erweitern.

Bei der Modellbildung wird zunächst einmal davon ausgegangen, daß die Hauptinduktivität im gesamten Strombereich konstant ist. Der Spannungsabfall über dem Statorwiderstand sowie der stromabhängige Spannungsabfall über den im Umrichter befindlichen Ventilen ist eine nichtlineare Funktion des Statorstroms und werde durch ein Polynom $\nu$-ter Ordnung gemäß

$$u_r (i_{S\alpha}) = u_{r0} + u_{r1} \cdot i_{S\alpha} + u_{r2} \cdot i_{S\alpha}^2 + \dots + u_{r\nu} \cdot i_{S\alpha}^\nu \tag{3.1}$$

approximiert.

Wählt man als Eingangsgröße die Differenz $\dot{\psi}_{S\alpha} = u_S = u_{S\alpha}{}^* - u_r(i_{S\alpha})$ (s. Bild 2), so kann man das folgende mathematisches Modell im Zeitbereich angeben

$$\frac{d}{dt}\begin{bmatrix} i_{S\alpha} \\ i_{R\alpha} \end{bmatrix} = \begin{bmatrix} 0 & -\dfrac{L_S \cdot R_R}{L_h^2 - L_R \cdot L_S} \\ 0 & \dfrac{L_S \cdot R_R}{L_h^2 - L_R \cdot L_S} \end{bmatrix} \cdot \begin{bmatrix} i_{S\alpha} \\ i_{R\alpha} \end{bmatrix} + \begin{bmatrix} -\dfrac{L_R}{L_h^2 - L_R \cdot L_S} \\ \dfrac{L_h}{L_h^2 - L_R \cdot L_S} \end{bmatrix} \cdot u_S \tag{3.2}$$

Für dieses kontinuierliche Modell (Gleichung (3.2)) kann man unter Berücksichtigung des Abtast- und Haltegliedes eine Differenzengleichung ermitteln, die die gleiche Ordnung besitzt wie das bisher betrachtete lineare Modell (Gleichung (2.11)), jedoch enthält dieses Modell einen integralen Anteil, so daß sich eine andere Zusammensetzung der diskreten Modellparameter ergibt.

Berücksichtigt man zusätzlich Gleichung (3.1), so erhält man folgende zu programmierende Schätzgleichung

$$\begin{aligned} \hat{i}_{S\alpha}(k) = &-\hat{a}_{N1} \cdot \hat{i}_{S\alpha}(k-1) - \hat{a}_{N2} \cdot \hat{i}_{S\alpha}(k-2) - \\ &\hat{a}_{201} \cdot \hat{i}_{S\alpha}^2(k-1) - \hat{a}_{202} \cdot \hat{i}_{S\alpha}^2(k-2) - \dots - \\ &\hat{a}_{\nu01} \cdot \hat{i}_{S\alpha}^\nu(k-1) - \hat{a}_{\nu02} \cdot \hat{i}_{S\alpha}^\nu(k-2) + \\ &\hat{b}_1 \cdot u_{S\alpha}{}^*(k-1) + \hat{b}_2 \cdot u_{S\alpha}{}^*(k-2) - c_{GI}. \end{aligned} \tag{3.3}$$

Dies entspricht einem nichtlinearen Schätzmodell nach Lachmann [5] und der Fehler zwischen Meß- und Modellgröße ist linear im zu schätzenden Parametervektor $\hat{p}$ mit

$$dim\,(\hat{p}) = (2\nu + 3 \times 1)$$

wobei $\nu$ der Grad des Polynoms darstellt, durch welches die Spannung über dem Widerstand approximiert wird. Das bedeutet, daß es möglich sein muß, die Parameter von Gleichung (3.3) unter Anwendung eines Parameterschätzverfahrens (z.B. RLS-Verfahren) zu bestimmen.

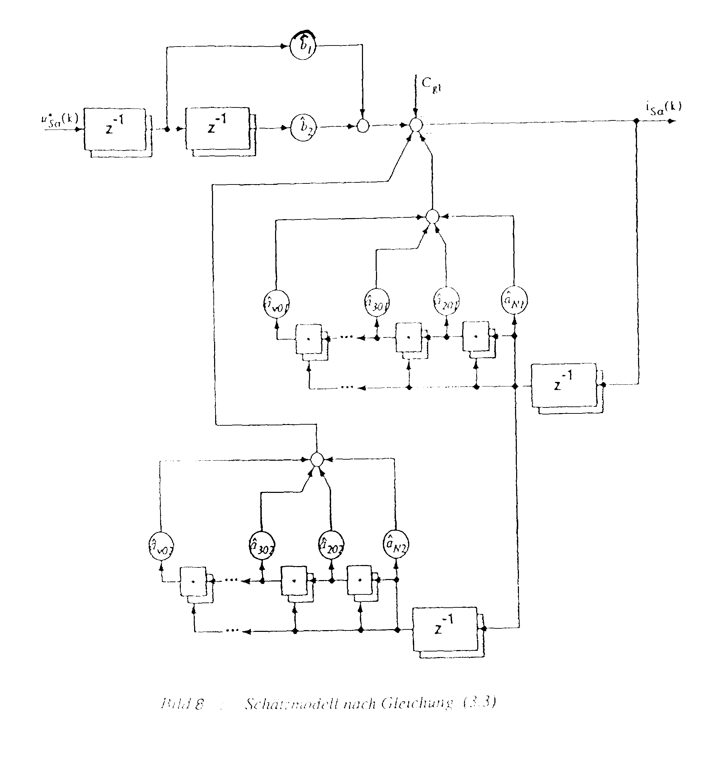

Das Schätzmodell nach Gleichung (3.3) ist in Bild 8 dargestellt.

Die Parameter von Gleichung (3.1) können nach der Schätzung wie folgt bestimmt werden:

$$u_{r1} = \frac{1}{\hat{b}_1}$$

$$u_{r2} = \frac{\hat{a}_{201}}{\hat{b}_1}$$

$$\vdots$$

$$u_{rv} = \frac{\hat{a}_{v01}}{\hat{b}_1}$$

$$u_{r0} \approx \frac{c_{gl}}{\hat{b}_1 + \hat{b}_2} \quad ,$$

(3.4)

so daß eine Schätzung des Statorflusses entsprechen den in 2.4 gemachten Ausführungen möglich ist.

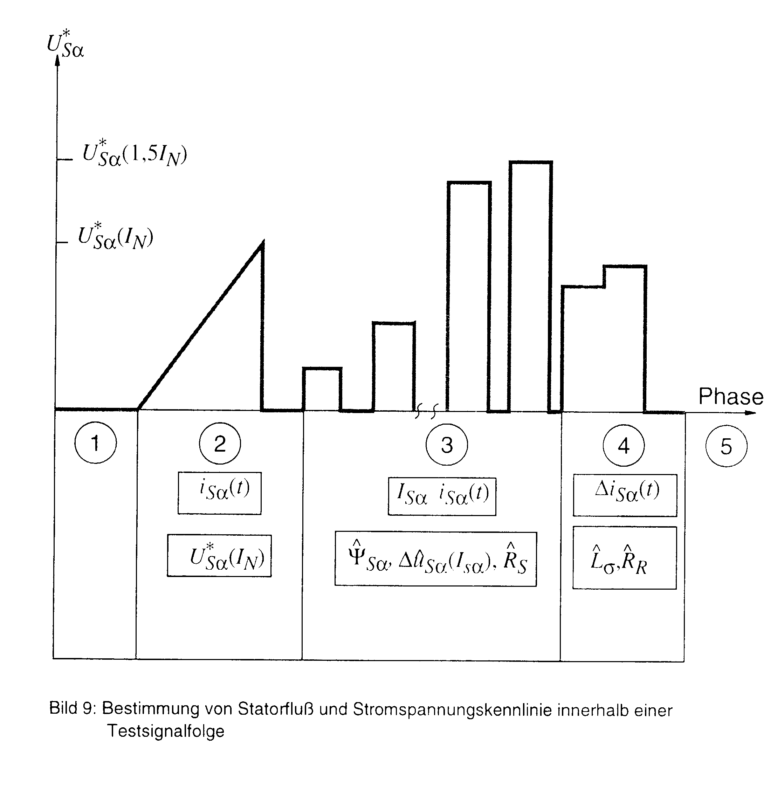

Eine weitere Möglichkeit besteht darin, den Ablauf wie in Bild 9 dargestellt vorzunehmen.

Das heißt:

- Phase 3: Ermittlung unterschiedlicher Flußschätzwerte entsprechend den Ausführungen in 3.1 und 2.4 (Bild 6 ) und speichern der Wertepaare ($I_{\mu 1}$, $\psi_{S\alpha 1}$) mit I = 1,2, ... Anzahl der durchgeführten Messungen.
- Phase 4: Bestimmung von Rotorwiderstand und Streuinduktivität entsprechend den Ausführungen in 2.3.
- Phase 5: Berechnung der stromabhängigen Hauptinduktivität entsprechend Gleichung (2.29) aus den unter Phase 3 abgespeicherten Wertepaaren und anhand der in Phase 4 ermittelten Streuinduktivität.
  Einstellung der Stromregler und des Feldmodells bei der Verwendung einer feldorientierten Regelung.

Formelzeichen und Indizes

| | |
|---|---|
| $a_i$, $b_i$ | diskrete Parameter |
| G | Übertragungsfunktion |
| $i_{Sa}$, $i_{Sb}$, $i_{Sc}$ | Strangströme |
| $i_{S\alpha}$, $i_{R\alpha}$, $i_{\mu\alpha}$ | Realteil von Stator-, Rotor- und Magnetisierungsstrom (in statorfesten Koordinaten) |
| k | diskr. Zeit (k=0,1,2...) |
| $L_h$, $L_{S\sigma}$, $L_{R\sigma}$ | Hauptinduktivität, statorseitige und rotorseitige Streuinduktivität |
| $L_{RS}$ | Induktivität $L_R = L_S = L_{RS}$ |
| $L_{RS\sigma}$ | Streuinduktivität $L_{R\sigma} = L_{S\sigma} = L_{RS\sigma}$ |
| $R_R$, $R_S$ | Rotor- und Statorwiderstand |
| $r_i$ | Hilfsvariablen |
| s | Variable der Laplace-Transformation |
| $T_{id}$ | Abtastzeit |
| $T_R$ | Rotorzeitkonstante |
| $\Delta T$ | Sicherheitszeit |
| $u_{S\alpha}$ | Statorspannung (Realteil) |
| $\Delta u_{S\alpha}$ | Fehlerspannung |
| z | Variable der z-Transformation |
| $\beta$ | Hilfsvariable |
| $\sigma$ | Totaler Streufaktor |
| $\sigma_{RS}$ | Rotor und statorseitiger Streufaktor $\sigma_R = \sigma_S = \sigma_{RS}$ |
| $\sigma(t)$ | Einheitssprungfunktion |
| $\psi$ | Fluß |
| $\wedge$ | Schätzwerte |

**Patentansprüche**

1. Verfahren zur Bestimmung der elektrischen Parameter eines von einem Pulswechselrichter (Umrichter) gespeisten Asynchronmotores im Stillstand, dadurch gekennzeichnet, daß

zunächst der Widerstand von Umrichter und Asynchronmotor in Abhängigkeit des gemessenen Strangstromes $i_{Sa}$ bei vorgegebenen Sollspannungen $U_S$ für den Umrichter bestimmt wird, wobei der Strangstrom $i_{Sa}$ vorteilhaft nicht unter 10 % des Nennstromes eines Leistungshalbleiters des Umrichters liegen sollte, daß anschließend

die an den Strängen des Asynchronmotors anliegende Ist-Spannung $\hat{u}_{Sa}$ und der Ständerwiderstand $\hat{R}_S$ mittels eines linearen Regressionsverfahren unter Verwendung der gemessenen Strangströme $i_{Sa}$ und der zugehörigen SollSpannungen $U_S$ gemäß Gleichung 2.8 errechnet wird, daß

anschließend zur Bestimmung der Streuinduktivität $\hat{L}_{RS\sigma}$ und des Rotorwiderstandes $\hat{R}_R$ im linearen oberen Bereich der gemäß Gleichung 2.8 ermittelten Stromspannungskennlinie im Anschluß an den Einschwingvorgang bei vorgegebenem Spannungs-Sollwert $U_{S1}$ ein zweiter höherer Spannungs-Sollwert $U_{S2}$ vorgegeben wird und der zeitliche Verlauf des Strangstromes $i_{Sa}$ gemessen wird, daß aus den gemessenen Stromwerten $i_{Sa}$ und den hierzu zuvor errechneten Spannungs-Istwerten $\hat{u}_S$ gemäß Gleichung 2.11, die Hilfsparameter $a_1$ und $a_2$, $b_1$ und $b_2$ mit den rekursiven Parameterschätzverfahren ($R_{LS}$ - Algorithmus) geschätzt werden, aus denen durch Umrechnung gemäß den Gleichungen 2.12 bis 2.26 die Streuinduktivitäten $L_{RS\sigma}$ und Rotorwiderstand $R_R$ berechnet werden, daß

anschließend zur Bestimmung der stromabhängigen Hauptinduktivität $\hat{L}_h$ die unerregte Asynchronmaschine mit einem Spannungs-Sollwert beaufschlagt und der zeitliche Verlauf des Strangstromes $i_{Sa}$ gemessen und gemäß Gleichung 2.27 der zeitliche Verlauf des Statorflusses $\hat{\psi}_{Sa}$ und dann anschließend gemäß Gleichung 2.29 die Hauptinduktivität $L_h$ errechnet wird, wobei dieser Meß- und Rechenvorgang für unterschiedliche Spannungs-Sollwerte $U_S$ wiederholt wird und daß

aus den zuvor errechneten stromabhängigen Hauptinduktivitäten $\hat{L}_h$ die Kennlinie $L_h = f(i_\mu)$ gemäß Gleichung 2.30 als Funktion des Magnetisierungsstromes $i_\mu$ approximiert wird

2. Verfahren zur Bestimmung der elektrischen Parameter eines von einem Umrichter gespeisten Asynchronmotores im Stillstand, dadurch gekennzeichnet, daß

zur Berechnung des Statorflusses $\hat{\psi}_{Sa}$ und des Statorwiderstandes $\hat{R}_S$ der unerregte Asynchronmotor mit einem Soll-Spannungswert beaufschlagt und der zeitliche Verlauf des Strangstromes $i_{Sa}$ in Abhängigkeit der Zeit gemessen wird und daß der Statorfluß $\hat{\psi}_{Sa}$ und der Stator widerstand $\hat{R}_S$ durch Approximation gemäß Gleichung 3.1 errechnet wird, daß

anschließend zur Bestimmung der Streuinduktivität $\hat{L}_{RS\sigma}$ und des Rotorwiderstandes $\hat{R}_R$ im linearen oberen Bereich der gemäß Gleichung 2.8 ermittelten Stromspannungskennlinie im Anschluß an den Einschwingvorgang bei vorgegebenem Spannungs-Sollwert $U_{S1}$ ein zweiter höherer Spannungs-Sollwert $U_{S2}$ vorgegeben wird und der zeitliche Verlauf des Strangstromes $i_{Sa}$ gemessen wird, daß aus den gemessenen Stromwerten $i_{Sa}$ und den hierzu zuvor errechneten Spannungs-Istwerten $\hat{u}_S$ gemäß Gleichung 2.11, die Hilfsparameter $a_1$ und $a_2$, $b_1$ und $b_2$ mit den rekursiven Parameterschätzverfahren ($R_{LS}$ - Algorithmus) geschätzt werden, aus denen durch Umrechnung gemäß den Gleichungen 2.12 bis 2.26 die Streuinduktivitäten $L_{RS\sigma}$ und Rotorwiderstand $R_R$ berechnet werden, daß

die Hauptinduktivität $\hat{L}_h$ gemäß Gleichung 2.29 aus den zuvor ermittelten Werten errechnet wird und daß

aus den zuvor errechneten stromabhängigen Hauptinduktivitäten $\hat{L}_h$ die Kennlinie $L_h = f(i_\mu)$ gemäß Gleichung 2.30 als Funktion des Magnetisierungsstromes $i_\mu$ approximiert wird.

$$u_{S\alpha}^{*} \qquad \frac{1/K_R \quad T_i}{} \qquad i_{S\alpha}$$

$$L_h R_R/L_R^{\,2} \qquad \Psi_{R\alpha} \qquad L_h \quad T_R$$

Bild 1: Wirkungsplan der Asynchronmaschine im Stillstand

Bild 2: Elektrisches Ersatzschaltbild von Umrichter und Motor im Stillstand

Bild 3

a) Einschaltverzögerung ca. 725 ns.
b) Einschaltverzögerung ca. 1,3 μs.

Bild 4: Wirkungsplan von Umrichter und Motor im Stillstand

EP 0 704 709 A2

Bild 5: Gemessene Sprungantworten am Versuchstand
a) Sprungantwort von 0 auf ca. 11,8 A
b) Sprungantwort von 11,8 A auf ca. 15 A

14

$\hat{U}_{S\alpha}$

$\hat{R}_S$

$i_{S\alpha}$

$F\{i_{S\alpha}\}$

$\dot{\psi}_{S\alpha}$

$\hat{\psi}_{S\alpha}$

Bild 6.: Wirkungsplan zur Schätzung des Statorflusses im Stillstand ohne Strangspannungserfassung

Bild 7: Testsignalfolgen zur Bestimmung der elektrischen Parameter im Stillstand

EP 0 704 709 A2

*Bild 8 — Schätzmodell nach Gleichung (3.3)*

EP 0 704 709 A2

Bild 9: Bestimmung von Statorfluß und Stromspannungskennlinie innerhalb einer Testsignalfolge